# EUROPEAN PATENT APPLICATION

(11) **EP 4 464 441 A1**
(43) Date of publication of application: **20.11.2024**
(21) Application number: 23740221.9
(22) Date of filing: 06.01.2023
(51) Int. Cl.: B23B 27/14, C23C 14/06

(54) **SURFACE-COATED CUTTING TOOL**

(30) Priority: 11.01.2022 JP 2022002351
(71) Applicant: Mitsubishi Materials Corporation, Tokyo 100-8117 (JP)
(72) Inventor: SEKIZAWA, Shoya, Tokyo 100-8117 (JP)
(74) Representative: Gille Hrabal Partnerschaftsgesellschaft mbB Patentanwälte
(86) International application number: PCT/JP2023/000161
(87) International publication number: WO 2023/136212

(57) **Abstract**

A surface-coated cutting tool includes a substrate and a coating layer provided on the substrate, wherein
1) the coating layer includes an alternating layer of A sublayers and B sublayers,
2) the A sublayers are each A Al₁₋ₐTiₐN (where 0.30 ≤ a ≤ 0.70),
3) the B sublayers are each Cr_{1-c}M2_{c}N (where M2 is B and/or Si, where 0.01 ≤ c ≤ 0.40),
4) the A and B sublayers each have an average thickness of 1 nm or more and 500 nm or less, and
5) the alternating layer has an average thickness of 0.3 um or more and 7.0 um or less,
6) the adjoining A and B sublayers satisfy the relation: 0.1 ≤ T_{A}/T_{B} ≤ 0.8 or 1.2 ≤ T_{A}/T_{B} ≤ 10.0, where T_{A} is the average thickness of the A sublayers and T_{B} is the average thicknesses of the B sublayers.

## Description

### Technical Field

The present invention relates to surface coated cutting tools (hereinafter referred to as "coated tools"). This application claims priority based on Japanese Patent Application No. 2022-2531 filed on January 11, 2022. The entire description in the Japanese patent application is hereby incorporated by reference.

### Background Art

Coated cutting tools are known that include substrates such as tungsten carbide (hereinafter referred to as WC) based cemented carbide and coating layers formed on the surfaces of the substrates in order to improve the service life of the tools. Various proposals have also been made regarding the composition and structure of the coating layers to further improve the cutting performance of coated tools.

For example, PTL 1 discloses a coated tool that includes a substrate, first layers comprising (TiₓAl₁₋ₓ)(C_{y}N_{1-y}) (where 0.20 ≤ x ≤ 0.60, 0 ≤ y ≤ 0.5) and second layers containing CrN alternately deposited on the surface of the substrate, and a coating layer composed of the topmost first layers. The coated tool demonstrates sufficient durability in a cutting test of SKD 61.

PTL 2 discloses a coated tool comprising a substrate, a bottom layer consisting of TiAlN layers and mixed layers of TiAlN and CrBN alternately laminated on the surface of a substrate, an intermediate layer consisting of a mixture of TiAlN and CrBN on the bottom layer, and a CrBN layer on the intermediate layer. This coated tool has improved cutting performance and durability against steel and non-ferrous workpieces, such as iron or copper alloys, which have low hardness and are prone to welding, and high-hardness steel materials, such as tempered steel having a hardness of about 50 HRC.

### Citation List

### Patent Literature

PTL1: Japanese Patent Application Unexamined Publication No. 2002-275618
PTL2: Japanese Patent Application Unexamined Publication No. 2007-63650

### Summary of Invention

### Technical Problem

An object of the present invention, which has been accomplished in view of the aforementioned circumstances and the aforementioned proposal, is to provide a coated tool having high durability even use in high-speed cutting of difficult-to-cut materials, such as Ti-based alloys.

### Solution to Problem

A surface-coated cutting tool according to a first embodiment of the present invention includes a substrate and a coating layer provided on the substrate, wherein
1) the coating layer includes an alternating layer of A sublayers and B sublayers,
2) the A sublayers each have a composition represented by the formula: Al₁₋ₐTiₐN (where 0.30 ≤ a ≤ 0.70),
3) the B sublayers each have a composition represented by the formula: Cr_{1-c}M2_{c}N (where M2 is at least one selected from the group consisting of B and Si, where 0.01 ≤ c ≤ 0.40),
4) the A sublayers each have an average thickness of 1 nm or more and 500 nm or less and the B sublayers each have an average thickness of 1 nm or more and 500 nm or less,
5) the alternating layer of the A sublayers and the B sublayers has an average thickness of 0.3 um or more and 7.0 um or less, and
6) the adjoining A and B sublayers satisfy the relation: 0.1 ≤ T_{A}/T_{B} ≤ 0.8 or 1.2 ≤ T_{A}/T_{B} ≤ 10.0, where T_{A} is the average thickness of the A sublayers and T_{B} is the average thicknesses of the B sublayers.

The surface cutting coated tool according to the first embodiment may satisfy the following condition (1):
(1) The alternating layer of the A sublayers and the B sublayers further includes one or more C sublayers with an average thickness of 0.3 um or more and 2.0 um or less at any position in the alternating layer, wherein the C sublayers each have a composition represented by the formula: Al_{1-d-g}Ti_{d}M3ₑN (where M3 is at least one selected from the group consisting of B and Si, 0.30 ≤ d ≤ 0.70, 0.00 ≤ e ≤ 0.30, and d ≠ a).

A surface-coated cutting tool according to a second embodiment includes a substrate and a coating layer provided on the substrate, wherein
1) the coating layer includes an alternating layer of A sublayers and B sublayers,
2) the A sublayer each have a composition represented by the formula: Al_{x-a-b}TiₐM1_{b}N (where M1 is at least one selected from the group consisting of B and Si, 0.30 ≤ a ≤ 0.70, and 0.01 ≤ b ≤ 0.30).
3) the B sublayers each have a composition represented by the formula: Cr_{1-c}M2_{c}N (where M2 is at least one selected from the group consisting of B and Si, where 0.01 ≤ c ≤ 0.40),
4) the A sublayers each have an average thickness of 1 nm or more and 500 nm or less and the B sublayers each have an average thickness of 1 nm or more and 500 nm or less, and
5) the alternating layer of the A sublayers and the B sublayers has an average thickness of 0.3 um or more and 7.0 um or less.

The surface cutting coated tool according to the second embodiment may further satisfy one or more of the following conditions (1) to (2):
(1) The alternating layers of the A sublayers and the B sublayers further includes one or more C sublayers with an average thickness of 0.3 um or more and 2.0 um or less at any position, wherein the C sublayers each have a composition represented by the formula: Al_{x-d-g}Ti_{d}M3ₑN (where M3 is at least one selected from the group consisting of B and Si, 0.30 ≤ d ≤ 0.70, 0.00 ≤ e ≤ 0.30, and d ≠ a and/or e ≠ b).
(2) the adjoining A and B sublayers satisfy the relation: 0.1 ≤ T_{A}/T_{B} ≤ 10.0, where T_{A} represents the average thickness of the A sublayers and T_{B} represents the average thicknesses of the B sublayers.

### Advantageous Effects of Invention

The embodiment of the surface coated cutting tool has high durability in high-speed cutting of difficult-to-cut materials, such as Ti-based alloys.

### Brief Description of Drawings

Fig. 1 is a schematic view illustrating a longitudinal section (cross-section perpendicular to the surface of the substrate) of the coating layer of the first embodiment of the invention; and
Fig. 2 is a schematic view illustrating a longitudinal section of the coating layer of the second embodiment of the invention.

### Description of Embodiments

The present inventor has extensively searched a coated tool having high durability, i.e., excellent cutting performance over a long period of use, even in cutting processes, such as high-speed cutting of Ti-based alloys (wet intermittent cutting with an end mill at a cutting rate of 80 m/min or more) in which a large thermal and mechanical load is applied to the cutting edge and the Ti-based alloy to be cut is adhered to the coated tool. Finally, the inventor has reached the following findings (1) to (3) regarding a reduction in adhesion which is caused by chemical reactions between the elements contained in the Ti-based alloy and the coating layer.
(1) Although a coating layer composed of a composite nitride containing Al and Ti can reduce welding or deposition, addition of B and Si, which are less soluble in the Ti-based alloy, to the composite nitride is more desirable for a reduction in welding or deposition.
(2) However, crystal grains with a hexagonal crystal structure are formed in the composite nitride containing Al and Ti as the content of B and Si increases, resulting in a decrease in the hardness of the coating layer and insufficient wear resistance of the coating layer.
(3) Even if crystal grains with a hexagonal crystal structure of the composite nitride containing Al and Ti are formed, a composite nitride layer mainly composed of Cr, which is difficult to form crystal grains with a hexagonal crystal structure, deposited on the composite nitride containing Al and Ti can prevent the hardness of the coating layer from decreasing and achieve sufficient wear resistance of the coating layer.

The coated tool of the embodiments of the present invention will now be described in detail. Throughout the specification and the claims, a numerical range expressed as "L to M" (L and M are both numerical values) includes the upper limit (M) and the lower limit (L), and in the case that only the upper limit is followed by a unit, the lower limit (L) has also the same unit.

The surface of the substrate is defined by a mean linear line that is arithmetically determined from a roughness curve of the interface between the substrate and the coating sublayer adjoining the substrate. According to this method of determining the mean line, if the diameter of the tool, which is the diameter of the substrate having a curved surface, is sufficiently large in relation to the thickness of the coating layer, the interface between the coating layer and the substrate can be treated as a plane, and the surface of the substrate can be determined in the same way.

High-speed machining of difficult-to-cut materials in the following first and second embodiments refers to wet intermittent machining of Ti-based alloys at a cutting rate of 80 m/min or more with an end mill, wet continuous machining of austenitic stainless steel at a cutting rate of 200 m/min or more with a turning insert, and side cutting of Ni-based alloys at a cutting rate of 45 m/min or more with an end mill, for example.

"Coating layer" is a generic term for layers, i.e., Ai sublayer, Bj sublayer, Ck sublayer (Ck sublayer exists only in the second embodiment and not in the first embodiment), bottom layer, top layer, and any layer that may occur incidentally, lying on the surface of the substrate.

A sublayers, B sublayers, and C sublayers are referred to collectively as an Ai sublayer, a Bj sublayer, and a Ck sublayer, respectively, but no distinct difference in usage is between the A sublayer and the Ai sublayer, between the B sublayer and the Bj layer, and between the C sublayer and the Ck sublayer.

### I. First embodiment

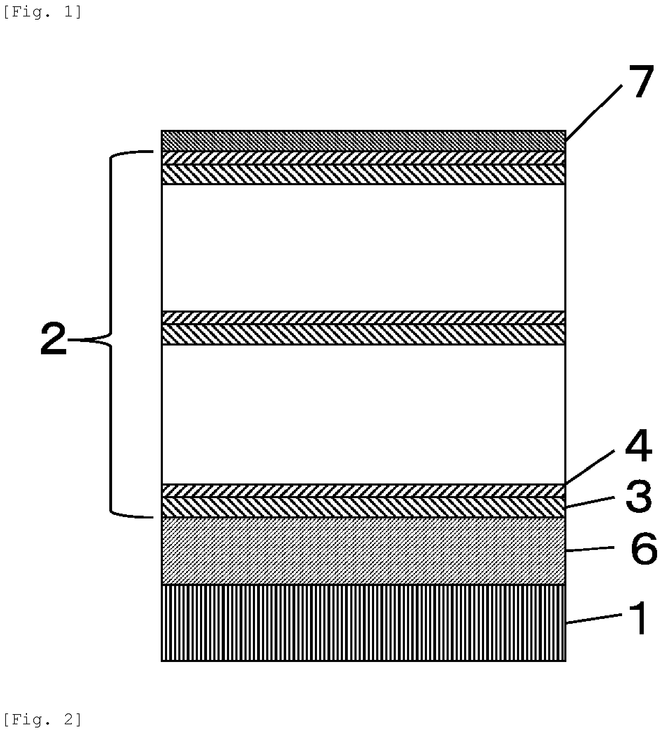

Fig. 1 is a schematic view illustrating a longitudinal section (a section perpendicular to the surface ignoring minute irregularities of the substrate in the case of an insert; or a section perpendicular to the central axis in the case of a shaft tool, such as an end mill or drill) of the coating layer of a coated tool according to the first embodiment of the invention. In this embodiment, the Ai sublayer (3) and the Bj sublayer (4) are alternately deposited (I = 1 to m, j = 1 to n, m is the number of A sublayers and n is the number of B sublayers, |m-n| ≤ 1) from the substrate (1) to the surface of the coated tool, i.e., the surface of the coating layer. Although Fig. 1 depicts the bottom layer (6) and the top layer (7), these layers may be omitted.

### 1. Alternating layer of A sublayers and B sublayers

As shown schematically in Fig. 1, the coating layer should preferably be an alternating layer (2) of Ai sublayers (3) and Bj sublayers (4) from the substrate (1) toward the surface of the tool (surface of the coating layer). It should be noted that the alternating layer (2) is not depicted in the white area in Fig. 1.

### (1) A sublayer

### (1-1) composition

Each A sublayer preferably has an average composition represented by Al_{1-a-b}TiₐM1_{b}N (where M1 is at least one selected from the group consisting of B and Si, 0.30 ≤ a ≤ 0.70, and 0.00 ≤ b ≤ 0.30). The phrase "M1 is at least one selected from the group consisting of B and Si" means M1 = B, M1 = Si, or M1 = B and Si.

The reasons for determining the values of subscripts **a** and **b** in the above-described ranges are as follows: A value of subscript **a** less than 0.30 leads to a decrease in hardness of A sublayers and insufficient wear resistance due to the formation of hexagonal crystal grains caused by an increase in Al content. A value of subscript **a** exceeding 0.70 leads to a decrease in the hardness and oxidation resistance of Al sublayer at high temperatures. A more preferred value of subscript **a** lies between 0.40 and 0.65.

A value of subscript **b** may be 0.00, in other words, M1 component is not essential. A value of subscript **b** of 0.01 or more however ensures improved welding resistance of the A sublayers, while a value of subscript **b** exceeding 0.30 causes brittle A sublayers to form and does not provide sufficient wear resistance. More preferably the value of subscript **b** ranges from 0.03 to 0.10

In the case that the value of subscript **b** is 0.00, in other words, no M1 component is contained, the average thickness of the A sublayers and B sublayers should preferably satisfies the relation 0.1 ≤ T_{A}/T_{B} ≤ 0.8 or 1.2 ≤ T_{A}/T_{B} ≤ 10.0 where T_{A} and T_{B} are the average thickness of the A sublayers and B sublayers, respectively.

In accordance with a typical example, described below, of the method of preparing the composition, the composition is prepared such that the ratio of (Al_{1-a-b}TiₐM1_{b}) to N is 1:1. However, the ratio may be unintentionally deviated from 1:1 in some cases. This also holds for the other composite nitrides discussed below.

### (1-2) Average thickness

The average thickness per A sublayer, i.e., the average thickness of the Ai layer, should range from 1 nm to 500 nm for the following reasons: An average thickness of less than 1 nm leads to insufficient improvements in wear resistance and chipping resistance of the Ai sublayers, while an average thickness exceeding 500 nm lead to lattice mismatch to adjoining Bj sublayers, and thus large internal strain in the Bj layer causing self-destruction. More preferably the average thickness of the Ai sublayers ranges from 5 nm to 200 nm.

### (2) B sublayer

### (2-1) Composition

It is preferred that the B sublayers each have an average composition represented by the formula: Cr_{1-c}M2_{c}N (where M2 is at least one selected from the group consisting of B and Si, where 0.01 ≤ c ≤ 0.40). The phrase "M2 is at least one of B and Si" M2 = B, M2 = Si, or M2 = B + Si.

The reasons for determining the value of subscript c in the above-described range is as follows: A value of subscript c less than 0.01 leads to an insufficient adhesion reduction brought about by the B sublayers, whereas a value of subscript c exceeding 0.40 leads to formation of brittle B sublayers and thus insufficient wear resistance. It is more preferable that the value of subscript c ranges from 0.05 to 0.20.

The B layers are deposited such that these layers are composed of a single phase and nitrides, such as Si₃N₄ and BN, do not precipitate. Since these nitrides have low crystallinity and low hardness, unexpected precipitation of nitrides may work as a starting point for destruction.

### (2-2) Average thickness

The average thickness per B layer, i.e., the average thickness of the Bj sublayer, should ranges from 1 nm to 500 nm for the following reasons. An average thickness of less than 1 nm leads to insufficient adhesion resistance of the Bj sublayer, whereas an average thickness exceeding 500 nm leads to large internal strain of the Bj sublayer readily causing self-destruction of the Bj sublayer. The average thickness of the Bj sublayer is more preferable to ranges from 5 nm to 200 nm.

### (3) Alternating layer of Ai sublayers and Bj sublayers

It is preferred that A sublayers and B sublayers are alternately deposited. In other words, each Ai sublayer and each Bj sublayer is in contact with each other in the stack. As mentioned above, the average thickness of both the Ai and Bj layers ranges from 1 nm to 500 nm (the average thickness of the Ai sublayers and that of the Bj sublayers may be the same or different), and the average thickness of the alternating layer of Ai sublayers and Bj sublayers should range from 0.3 um to 7.0 µm.

An average thickness of less than 0.3 um of the alternating layer of Ai sublayers and Bj sublayers leads to insufficient welding resistance and wear resistance, whereas an average thickness exceeding 7.0 um leads to large internal distortion causing self-destruction. Preferably, the average thickness should range from 1.0 µm to 5.0 µm.

It is preferred that the average thicknesses T_{A} and T_{B} of the adjoining Ai sublayer and Bj sublayer satisfy the relation: 0.1 ≤ T_{A}/T_{g} ≤ 0.8 or 1.2 ≤ T_{A}/T_{g} ≤ 10.0 in the case that M1 is not contained (b = 0.00) whereas the average thicknesses satisfy the relation: 0.1 ≤ b ≤ 0.30 and 0.1 ≤ T_{A}/T_{g} ≤ 10.0 in the case that Ma is contained, for the following reasons: In the case that M1 is not contained, a ratio T_{A}/T_{B} of less than 0.1 or greater than 10.0 leads to lattice mismatch between the Ai and Bj sublayers causing self-destruction of the alternating layer, whereas a ratio T_{A}/T_{B} of greater than 0.8 and less than 1.2 may form an amorphous mixture of the A and B sublayers causing insufficient wear resistance. In the case that M1 is contained, a ratio T_{A}/T_{g} less than 0.1 or greater than 10.0 may lead to lattice mismatch between the Ai sublayer and Bj sublayer causing self-destruction of the alternating layer.

In the first embodiment, the ratio T_{A}/T_{B} is calculated as follows: For example, in the case that a deposit of five sublayers, Aj, Bi, Aj+1, Bi+1, and Aj+2 sublayers, are targets of measurement, the ratio T_{A}/T_{g} represents the average of the four ratios: [Aj]/[Bi], [Aj+1]/[Bi], [Aj+1]/[Bj+1], and [Aj+2]/[Bi+1] where [Aj] represents the average thickness of the Aj sublayers and [Bi] represents the average thickness of the Bi sublayers.

In the alternating layer of the Ai and Bj sublayers, the sublayer closest to the substrate may be either the bottommost Ai or Bj sublayer, while the sublayer closest to the surface of the tool may also be either the topmost Ai or Bj sublayer. In the alternating layer of the Ai and Bj sublayers, the total number (m+n) of layers of the Ai and Bj sublayers is not restricted. The preferred total number ranges from 10 to 100.

### (5) Other layers

### (5-1) More desirable layer to exist

Although the aforementioned issue can be adequately solved with only the alternating layer (2) of Ai and Bj sublayers; a bottom layer (6) may be optionally provided between the substrate (1) and the alternating layer (2), and/or a top layer (7) may be optionally provided on the alternating layer or the surface of the tool, in addition to the alternating layer, as shown in Fig. 1.

### (5-1-1) Bottom layer

The bottom layer may be provided to more tightly bond the alternating layer of the Ai and Bj sublayers to the substrate. Examples of the bottom layer include, but are not limited to, composite nitride layers of Al and Ti, composite nitride layers of Al, Ti and Si, and composite nitride layers of Al and Cr (the compositions of these layers may include their nonstoichiometric composition). The average thickness of the bottom layer may be, for example, 0.3 to 5.0 um. The bottom layer may have the same composition as the Ai sublayer. In the case that the layer adjoining the bottom layer is the bottommost Ai sublayer, the bottom layer is indistinguishable from the adjoining Ai sublayer and thus the bottom layer is in contact with the bottommost Bj sublayer.

### (5-1-2) Top layer

The top layer may be provided on the surface of the alternating layer of the Ai and Bj sublayers, which is the surface of the tool. The top layer may be, for example, a TiN layer. The TiN layer, which has a golden color tone, can be used, for example, as an identification layer to determine whether the coated tool has not been used or has been used from a change in the color tone of the surface of the coated tool. The TiN identification layer may have an average thickness in the range of, for example, 0.1 to 1.0 µm.

### (5-2) Layer that may occur incidentally

In this embodiment, each layer is deposited such that no layers are formed, besides the A sublayers, the B sublayers, the bottom layer, and the top layer. Unintentional fluctuations in pressure and/or temperature may however occur in the deposition system when the type of the layer to be deposited is changed. In such a case, any layer with a different composition than these layers may be unintentionally or incidentally formed between these layers. This layer is referred to as a layer that may be incidentally formed.

### 2. Substrate

### (1) Material

The substrate of this embodiment may be composed of any conventional material that can achieve the aforementioned object. Examples of such preferable material include cemented carbides, such as WC-based cemented carbide that may further contain Co, Ti, Ta, and Nb, in addition to WC; Cermets containing TiC, TiN, or TiCN as a main component; ceramics, such as titanium carbide, silicon carbide, silicon nitride, aluminum nitride, and aluminum oxide; cBN sinter, and diamond sinter.

### (2) Shape

The substrate can be processed into any shape suitable for cutting tools. Examples of such a shape include shapes of inserts, end mills, and drills.

### II. Second embodiment

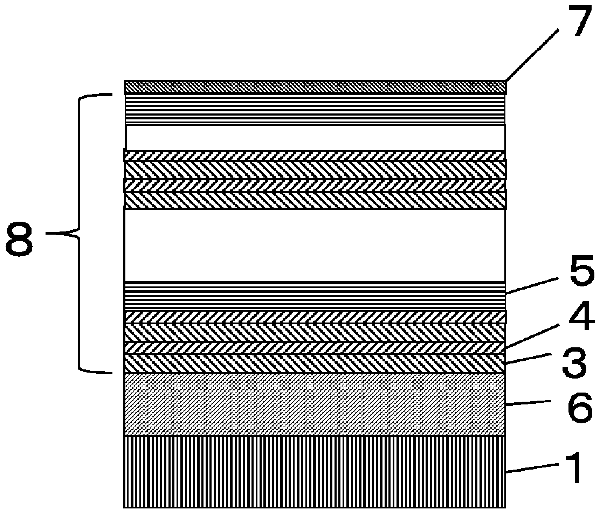

Fig. 2 is a schematic view illustrating a longitudinal section of the coating layer of a coated tool according to the second embodiment of the invention. The tool includes a substrate (1); an alternating layer (8) of Ai sublayers (3) and Bj sublayers (4) in contact with each other from the substrate (1) toward the surface of the tool (the surface of the coating layer); and one or more Ck sublayers (5) disposed in the alternating layer (where I = 1 to m, j = 1 to n where m and n are the number of layers, 1 ≤ k ≤ p where p will be described below). The bottom layer (6) and top layer (7) may be omitted from the configuration shown in Fig. 2.

### 1. One or more Ck layers disposed at any portion in alternating layer of Ai and Bj sublayers

The coating layer of this embodiment should preferably include one or more Ck sublayers (5) disposed at any position in the alternating layer of Ai sublayers (3) and Bj sublayers (4) extending from the substrate to the surface of the tool or coating layer (9), as shown schematically in Fig. 2. It should be understood that the Ai sublayers (3), the Bj sublayers (4), and Ck sublayer (s) (5) are also present in the white area in Fig. 2.

Since the Ai and Bj sublayers are the same as those described in the first embodiment, redundant description is omitted. Any number of Ck sublayers may be disposed. The number is preferably 15, more preferably 10.

Also in the case that the C sublayer is present, it is preferred that at least five consecutive alternating A and B sublayers, such as A sublayer, B sublayer, A sublayer, B sublayer, A sublayer, B sublayer, A sublayer, B sublayer, A sublayer, B sublayer are present with proviso that the C layer is regarded as not being present.

The coating layer, including one or more Ck sublayers disposed at any position in the alternating layer of Ai and Bj sublayers, preferably has an average thickness in the range of 0.3 um to 7.0 um, like the average thickness of the alternating layer of Ai and Bj sublayers.

An average thickness less than 0.3 um of the coating layer fails to achieve sufficiently high welding resistance and wear resistance, whereas a thickness exceeding 7.0 um leads to an increase in internal strain causing ready self-destruction of the coating layer.

The preferred range of the ratio T_{A}/T_{B} is the same as in the first embodiment where T_{A} and T_{B} represents the average thicknesses of adjoining Ai and Bj sublayers, respectively. The method of determining the ratio T_{A}/T_{B} is also the same as in the first embodiment where the existence of the Ck sublayer is ignored (assuming that the Ck sublayer does not exist). In the case of a deposition of five layers, for example, Aj, Bi, Aj+1, Bi+1, and Aj+2 layers are used for determination of the ratio.

### (1) C sublayer

### (1-1) Composition

The C sublayers preferably have an average composition represented by Al_{1-d-e}Ti_{d}M3ₑN (where M3 is at least one selected from the groups consisting of B and Si, 0.30 ≤ d ≤0.70, and 0.00 ≤ e ≤ 0.30, where d ≠ a and/or e ≠ b. The phrase "M3 is at least one of B and Si" means M3 = B, M3 = Si, or M3 = B+Si.

The values of d and e are determined as in the above ranges for the following reasons: A value of subscript d less than 0.30 leads to formation of hexagonal crystal grains due to an increase in Al content and thus an increase in the hardness of the C sublayers, resulting in insufficient wear resistance. More preferably, the value of subscript d ranges from 0.40 to 0.65.

Although the M3 component may be omitted (e = 0.00), the existence of the M component (e > 0.00) ensures a further improvement in weld resistance of the C sublayer. A value of subscript **e** exceeding 0.30 however leads to brittle C sublayers causing insufficient wear resistance. A more preferred value of subscript **e** ranges from 0.01 to 0.10.

### (1-2) Average thickness

The average thickness per C sublayer, i.e., the average thickness of the Ck sublayer, should ranges from 0.3 um to 2.0 µm for the following reasons: An average thickness of less than 0.3 um leads to insufficient wear resistance of the Ck sublayer, whereas an average thickness exceeding 2.0 um leads to a relatively large thickness of the Ck sublayer in comparison with the alternating layer of Ai and Bj sublayers. Such a thick Ck sublayer causes insufficient welding resistance in the portion containing the Ck sublayer disposed in the alternating layer of Ai and Bj sublayers. The average thickness of the Ck layer should preferably be more than 0.4 um and less than 1.0 µm.

### (2) Position of disposed Ck sublayer

It is preferred that the Ck sublayer is disposed at any position in the alternating layer of the Ai and Bj sublayers. The phrase "the Ck layer is disposed at any position" indicates that the Ck sublayer is present between the two adjacent Ai sublayers, between the two adjacent Bj sublayers, between the adjacent Ai and Bj sublayers, between the alternating layer of the Ai and Bj sublayers and the substrate, i.e. adjacent to the substrate (between the bottom layer if present, i.e., adjacent to the bottom layer), or on the alternating layer of Ai and Bj sublayers or between the alternating layer of the Ai and Bj sublayers and the top layer if present. In the case that the Ck sublayer is disposed, three adjacent layers are as follows: AiCkAi+1, BjCkBj+1, AiCkBj, BjCkAi, CkAiBj "on the substrate or bottom layer if present", CkBjAi "on the substrate or bottom layer if present", BjAiCk (Ck is in contact with the tool surface or top layer when present), or AiBjCk (Ck is in contact with the alternating laminate of Ai and Bj layers or the top layer if present).

The total number (i+j+k) of Ai, Bj and Ck sublayers may be any number in the case that one or more Ck sublayers are disposed in the alternating layer of Ai and Bj sublayers. A preferred total number is 10 or more and 100 or less. Each C sublayer may be disposed any position in the alternating layer. In the case that three or more Ck sublayers are disposed, the total number of the Ai and Bj sublayers between adjacent Ck sublayers may be the same or different.

The bottommost sublayer, closest to the substrate, may be an Ai, Bj, or Ck sublayer, and the topmost sublayer, closest to, the tool surface may also be an Ai, Bj, or Ck sublayer.

### (3) Other layers

The description of the other layers is basically the same as the first embodiment, with the proviso that "the alternating layer of the Ai and Bj sublayers to the substrate" on the bottom layer should be replaced by "the alternating layer of the Ai and Bj sublayers and one or more interposed Ck sublayers to the substrate", "the surface of the alternating layer of the Ai and Bj sublayers" on the top layer should be replaced by "the surface of the alternating layer of the Ai and Bj sublayers and one or more interposed Ck sublayers", and "besides the A sublayers, the B sublayers, the bottom layer, and the top layer" on the layer that may occur incidentally should be replaced by "besides the A sublayers, the B sublayers, the C sublayer(s), the bottom layer, and the top layer".

### 2. Substrate

The description of the substrate is the same as in the first embodiment.

### III. Determination

Each tool sample is cut into a longitudinal section with a focused ion beam (FIB) system, and the thickness of each layer is measured with a scanning electron microscope (SEM) or transmission electron microscope (TEM). For the alternating layer, at least five sublayers (for T_{A}/T_{g} measurement, five or more consecutive sublayers of the same type, for example, five consecutive layers, such as an A sublayer, a B sublayer, an A sublayer, a B sublayer, an A sublayer, a B sublayer, an A sublayer, a B sublayer, an A sublayer, and a B sublayer) are measured for each of the A and B sublayers. If there are fewer than 5 sublayers, all the sublayers concerned are measured. The thickness of each layer is determined at five points. The sample may be observed at any magnification suitable for measurement of the thickness. For example, A and B sublayers may be observed at 50,000 to 500,000x, and C sublayers and the entire coating layer may be at 10,000 to 10,000x. The average value of the five points shall be the average thickness of each layer. In addition, energy dispersive X-ray analysis (EDS) with SEM or TEM, Auger electron spectroscopy (AES), and electron probe micro analyzer (EPMA) are used for cross-sectional observation, the compositions of A, B, and C sublayers are measured at five locations for each layer, and the average composition is calculated from the average of these measurements.

### IV. Production

The coating layers of the first and second embodiments can be produced, for example, by the following PVD process. The second embodiment differs from the first embodiment in that the second embodiment involves the step of forming the C sublayer. The steps of forming the bottom and top layers are not mandatory in either the first or second embodiments.

The arc ion plating (AIP) system is purged with a nitrogen atmosphere. An AlTiM1 alloy target having a composition: Al_{100-a'-b'}Ti_{a'}M1_{b'} (where M1 is at least one selected from the group consisting B and Si, where 20 ≤a' ≤ 80, and 0 ≤ b' ≤ 40) is prepared for Ai sublayers; a CrM2 alloy target having a composition: Cr_{100-c'}M2_{c'} (where M2 is at least one selected from the group consisting of B and Si, where 1 ≤ c' ≤ 50) is prepared for Bj sublayers; and an AlTiM3 alloy target having a composition Al_{100-d'-e'}Ti_{d'}M3_{e'} (where M3 is at least one selected from the group consisting of B and Si, where 20 ≤ d' ≤ 80, 0 ≤ e' ≤ 40) is prepared for Ck sublayer(s). For example, an optional AlTi, AlTiSi, or AlCr alloy target is prepared for a bottom layer depending on a desired composite nitride layer; and, for example, an optional Ti target is prepared for a top layer. Arc discharges are sequentially generated between these targets and an anode to deposit a bottom layer, Ai sublayers, Bj sublayers, Ck sublayers, and a top layer each with a predetermined average thickness. The composition of each target is expressed as an integer ratio of atoms.

The above description supports the following features:

### (Feature 1)

A surface-coated cutting tool comprising:
a substrate and a coating layer disposed on the substrate, wherein
1) the coating layer includes an alternating layer of A sublayers and B sublayers,
2) the A sublayers each have a composition represented by the formula: Al_{1-a-b}TiₐN (where 0.30 ≤ a ≤ 0.70),
3) the B sublayers each have a composition represented by the formula: Cr_{1-c}M2_{c}N (where M2 is at least one selected from the group consisting of B and Si, where 0.01 ≤ c ≤ 0.40),
4) the A sublayers each have an average thickness of 1 nm or more and 500 nm or less and the B sublayers each have an average thickness of 1 nm or more and 500 nm or less,
5) the alternating layer of the A sublayers and the B sublayers has an average thickness of 0.3 um or more and 7.0 um or less, and
6) the adjoining A and B sublayers satisfy the relation: 0.1 ≤ T_{A}/T_{B} ≤ 0.8 or 1.2 ≤ T_{A}/T_{B} ≤ 10.0, where T_{A} represents the average thickness of the A sublayers and T_{B} represents the average thicknesses of the B sublayers.

### (Feature 2)

The surface coated cutting tool according to Feature 1, wherein there is a portion where five or more of the A sublayers and five or more of the B sublayers are continuously present.

### (Feature 3)

The surface-coated cutting tool according to Feature 1 or 2, wherein the alternating layer of the A sublayers and the B sublayers further includes one or more C sublayers with an average thickness of 0.3 um or more and 2.0 um or less at any position in the alternating layer, wherein the C sublayers each have a composition represented by the formula: Al_{1-d-e}Ti_{d}M3ₑN (where M3 is at least one selected from the group consisting of B and Si, 0.30 ≤ d ≤ 0.70, 0.00 ≤ e ≤ 0.30, and d ≠ a).

### (Feature 4)

A surface-coated cutting tool comprising:
a substrate and a coating layer disposed on the substrate, wherein
   1) the coating layer includes an alternating layer of A sublayers and B sublayers,
   2) the A sublayer each have a composition represented by the formula: Al_{1-a-b}TiₐM1_{b}N (where M1 is at least one selected from the group consisting of B and Si, 0.30 ≤ a ≤ 0.70, and 0.01 ≤ b ≤ 0.30).
   3) the B sublayers each have a composition represented by the formula: Cr_{1-c}M2_{c}N (where M2 is at least one selected from the group consisting of B and Si, where 0.01 ≤ c ≤ 0.40),
   4) the A sublayers each have an average thickness of 1 nm or more and 500 nm or less and the B sublayers each have an average thickness of 1 nm or more and 500 nm or less, and
   5) the alternating layer of the A sublayers and the B sublayers has an average thickness of 0.3 um or more and 7.0 um or less.

### (Feature 5)

The surface-coated cutting tool according to Feature 4, wherein the adjoining A and B sublayers satisfy the relation: 0.1 ≤ T_{A}/T_{B} ≤ 10.0, where T_{A} represents the average thickness of the A sublayers and T_{B} represents the average thicknesses of the B sublayers.

### (Feature 6)

The surface-coated cutting tool according to Feature 3 or 4, wherein the alternating layer of the A sublayers and the B sublayers further includes one or more C sublayers with an average thickness of 0.3 um or more and 2.0 um or less at any position in the alternating layer, wherein the C sublayers each have a composition represented by the formula: Al_{1-d-e}Ti_{d}M3ₑN (where M3 is at least one selected from the group consisting of B and Si, 0.30 ≤ d ≤ 0.70, 0.00 ≤ e ≤ 0.30, where d ≠ a and/or ) e ≠ b.

### (Feature 7)

The surface coated cutting tool according to Feature 5 or 6, wherein there is a portion where five or more of the A sublayers and five or more of the B sublayers are continuously present.

### (Feature 8)

The surface coated cutting tool according to any one of Features 1 to 7, further comprising a bottom layer directly above the substrate.

### (Feature 9)

The surface coated cutting tool according to any one of Features 1 to 8, wherein the top surface of the coating layer is a top layer.

### Examples

The invention will now be described by way of examples that are not to be construed as limiting the invention.

### (1) Production of substrate

Raw powders of WC, TiC, VC, TaC, NbC, Cr₃C₂, and Co were blended according to the formulations shown in Table 1. Wax was added and the mixture was ball-milled in acetone for 24 hours, dried under reduced pressure, and pressed under a pressure of 98 MPa into a green compact with a predetermined shape.

The green compact was sintered under vacuum to form a sintered round bar with a diameter of 6 mm for forming substrates. The sintered round bar was subjected to a grinding process to produce end mill substrates 1 to 4 made of WC-based cemented carbide and having a four-blade square shape with a cutting edge that has diameter of 6 mm and a length of 13 mm. Each of substrates 1 to 4 was ultrasonically cleaned in acetone and the dried.

### (2) Production of coating layer

The substrates were mounted along the periphery at a predetermined radial distance from the center axis on a turn table of an AIP system. A target (cathode) of AlTiM1 alloy with a predetermined composition, a target of CrM2 alloy with a predetermined composition, a target of AlTiM3 alloy with a predetermined composition, targets of AlTi, AlTiSi and AlCr alloys, respectively, for a bottom layer, and a Ti target for a top layer were placed in the AIP system.

After bombarding treatment of each of substrates 1 to 4, Examples 1 to 24 and 49 to 76 of coated tools corresponding to the first embodiment were produced through Processes 1) to 5) in Section (2-1), and Examples 25 to 48 and 77 to 100 of coated tools corresponding to the second embodiment were produced through Processes 1') to 6') in Section (2-2). These examples are shown in Tables 12 to 27.

### (2-1) Example of coated tools corresponding to the first embodiment

### 1) Deposition of bottom layer

In some examples, the bottom layer was deposited through the following procedure. Nitrogen reaction gas was introduced into the AIP system to create a nitrogen atmosphere of 3.5 Pa for deposition of the bottom layer, as shown in Table 11; the substrate spinning on the rotary table was maintained at 480°C; a DC bias voltage of -45 V was applied to the substrate; and arc discharges were generated between the anode and targets of AlTi, AlTiSi, and AlCr alloys corresponding to the compositions of the bottom layer to deposit bottom layers on the substrates. In Tables 2 to 9, the compositions of the targets are shown in the form of the integer ratio of each atom with the sum of the ratios being 100, which are different from those of the A, B, and C layers.

### 2) Deposition of Ai sublayer

Nitrogen reaction gas was introduced into the AIP system, and an arc discharge was generated between the AlTiCrM1 alloy target and the anode to deposit an Ai sublayer. The nitrogen atmosphere pressure, substrate temperature, and bias voltage were those shown in Tables 2, 3, 6 and 7.

### 3) Deposition of Bj sublayer

An arc discharge was generated between the CrM2X alloy target and an anode to deposit a Bj sublayer. The nitrogen atmosphere pressure, substrate temperature, and bias voltage were those shown in Tables 2, 3, 6, and 7.

### 4) Deposition of alternating layer of Ai sublayers and Bj sublayers

The depositions of Procedures 2) and 3) were repeated predetermined times to deposit an alternating layer of Ai and Bj sublayers with the number of sublayers shown in Tables 12, 13, 14, 15 and 20 to 23.

### 5) Deposition of top layer

In some examples, a top layer was deposited through the following procedure. Nitrogen reaction gas was introduced into the AIP system, and the nitrogen atmosphere was adjusted to a pressure of 4.0 Pa for deposition of a top layer as shown in Table 11; the temperature of the substrate spinning on the turn table was maintained at 500°C; a bias voltage of -75 V was applied to generate an arc discharge between the Ti target corresponding to the composition of the top layer. The top layer was thereby deposited.

### (2-2) Example of coated tools corresponding to the second embodiment

### 1') Deposition of bottom layer

In some cases, a bottom layer was deposited as in Procedure 1) in the first embodiment.

### 2') Deposition of Ai sublayer

The A sublayers were deposited under the conditions shown in Tables 4, 5, 8 and 9, which corresponds to Procedure 2) of the first embodiment.

### 3') Deposition of Bj sublayer

The B sublayers were deposited under the conditions shown in Tables 4, 5, 8 and 9, which corresponds to Procedure 3) of the first embodiment.

### 4') Deposition of one or more Ck sublayers at any given position in alternating layer of Ai and Bj sublayers.

The Ck sublayer was deposited so as to be disposed at any position as described above. The conditions for deposition of Ck sublayers are described in Procedure 5'). In a first mode, the Ck sublayer was deposited on the bottom layer, and then the Ai and Bj sublayers were alternately deposited. In a second mode, Procedures 1) and 2) were repeated by predetermined cycles to form an alternating layer of Ai and Bj sublayers, the Ck sublayer was deposited on the alternating layer, and Procedures 1) and 2) were again repeated by predetermined cycles to form another alternating layer of Ai and Bj sublayers. As a result, the Ck sublayer is between adjacent Ai sublayers, between adjacent Bj sublayers, or between an Ai sublayer and the adjacent Bj sublayer. In this mode, one or more optional Ck sublayers were deposited in the same manner. In a third mode, a Ck sublayer was deposited after the alternating layer of Ai and Bj sublayers. The Ck sublayer or the predetermined number of Ck sublayers were thereby disposed at a predetermined position or positions in the alternating layer shown in Tables 16, 17, 18, 19 and 24 to 27. In the tables, the position of each C sublayer is represented by the ordinal number counting from the bottommost sublayer (the first sublayer) on the substrate or the bottom layer if present toward the coated tool surface.

### 5') Deposition of Ck sublayer

An arc discharge was generated between the AlTiM3 alloy target and the anode under the conditions shown in Tables 4, 5, 8, and 9 on the pressure of the nitrogen atmosphere, substrate temperature, and bias voltage to deposit Ck sublayers with compositions and average thickness per sublayer as shown in Tables 16, 17, 18, 19 and 24 to 27.

### 6') Deposition of top layer

In some cases, the top layer was deposited under the same conditions as in Procedure 5).

### (3) Comparative Examples

For comparison, Substrates 1 to 4 were each ultrasonically cleaned in acetone, dried, mounted along the periphery at a predetermined distance in the radial direction from the center axis on the turn table of the AIP system, and subjected to bombardment treatment, like Examples 1 to 100, under Conditions 1' to 16' shown in Table 10. Surface coated inserts 1' to 16' (hereinafter referred to as "Comparative Examples 1' to 16'") were thereby manufactured as shown in Tables 28 and 29.

The average composition and average thickness were calculated for each of Examples 1 to 100 and Comparative Examples 1' to 16' produced as described above, using the method described above (the thickness was measured at five locations of all the C sublayers in the case of less than five C sublayers.

Tables 12 to 29 show the results of measurement and calculation, where "overall average thickness (µm)" indicates the average thickness (um) of the sum of the thicknesses of all Ai and Bj sublayers in the first embodiment, and the average thickness (um) of the sum of the thicknesses of all Ai, Bj and Ck sublayers in the second embodiment. In Tables 28 and 29, "-" indicates not present.

**[Table 1]**

| Substrate | Composition (mass%) | | | | | | |
|---|---|---|---|---|---|---|---|
| | Co | TiC | VC | TaC | NbC | Cr₃C₂ | WC |
| 1 | 5.6 | 0.0 | 0.0 | 0.0 | 0.0 | 0.7 | Balance |
| 2 | 8.2 | 0.0 | 0.4 | 0.0 | 0.0 | 0.5 | Balance |
| 3 | 9.8 | 4.3 | 0.0 | 5.1 | 2.3 | 0.0 | Balance |
| 4 | 12.1 | 0.0 | 0.0 | 0.0 | 0.0 | 1.0 | Balance |

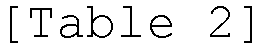

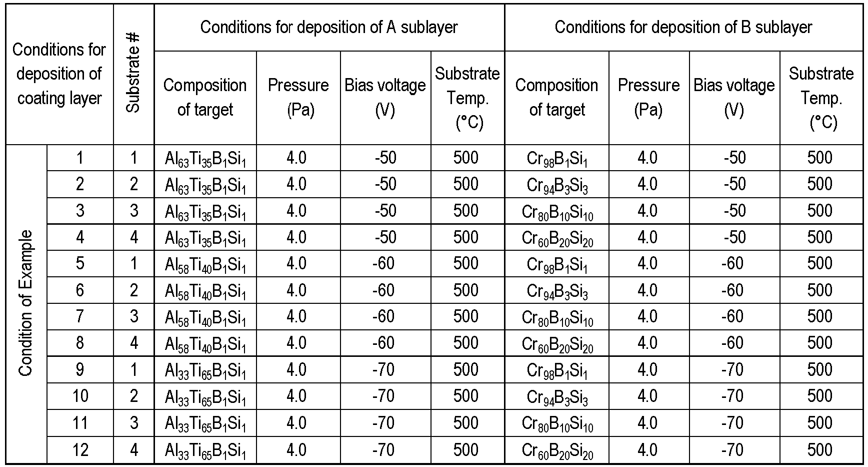

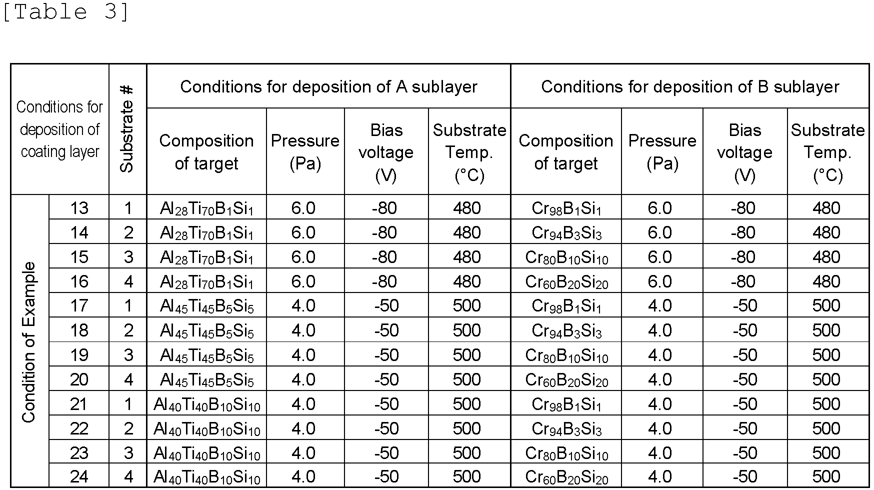

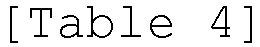

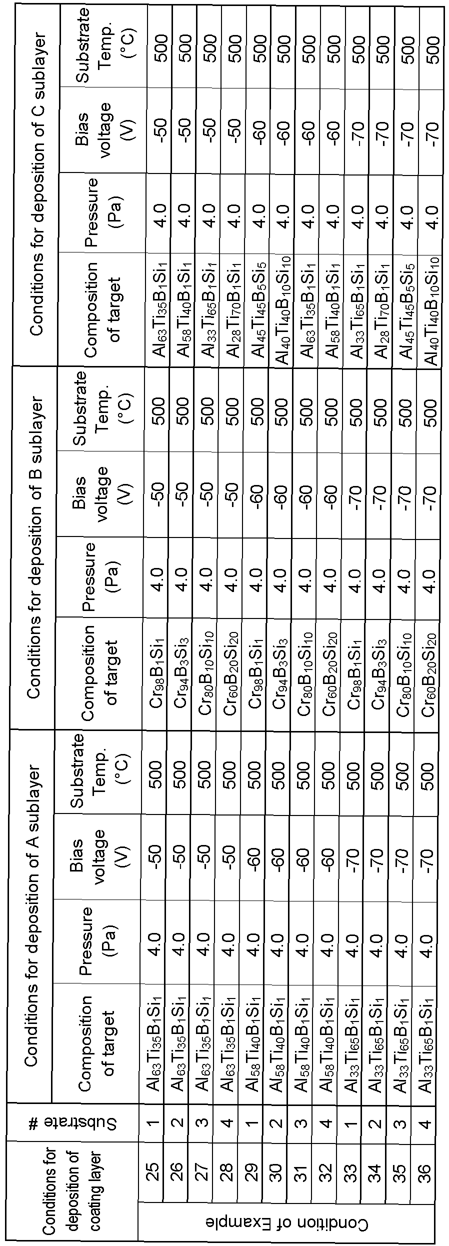

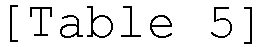

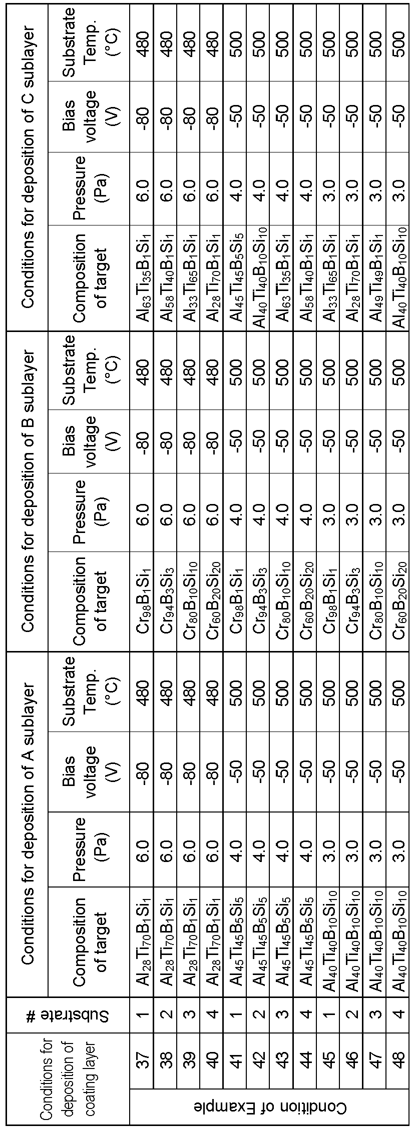

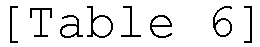

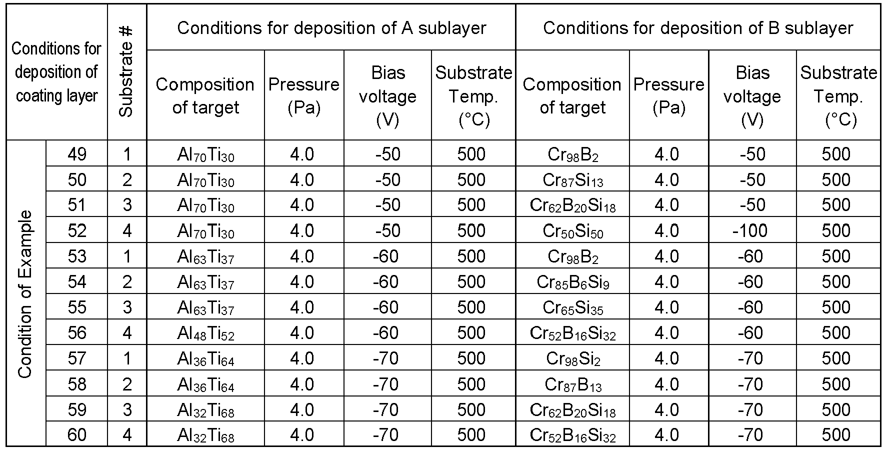

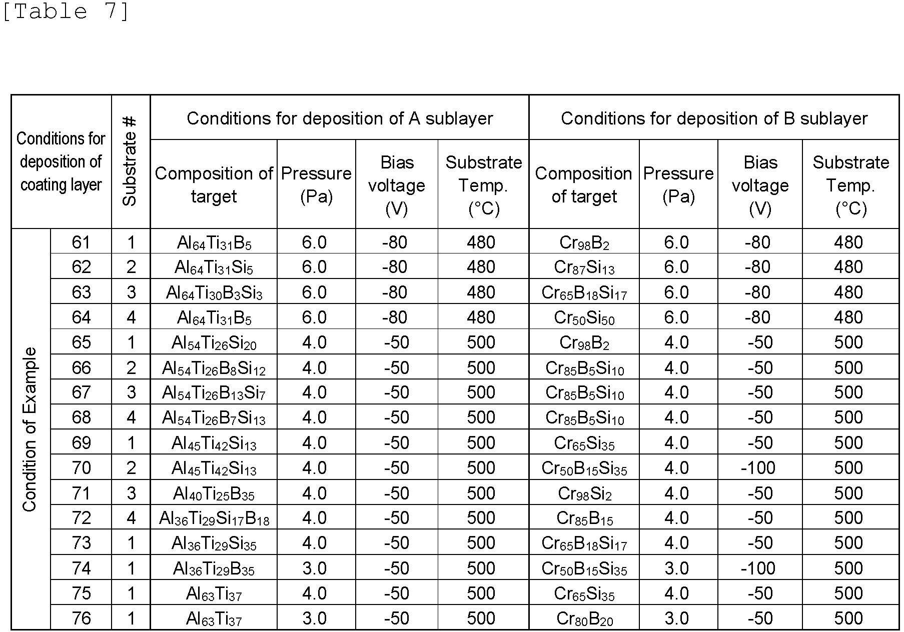

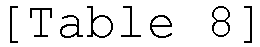

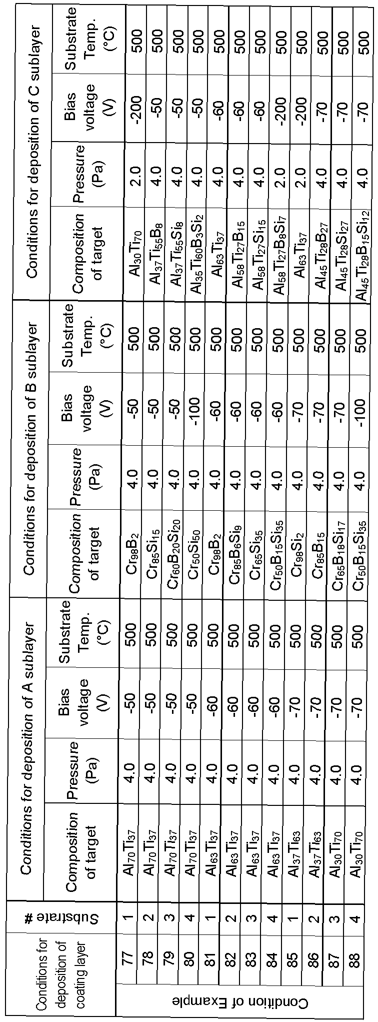

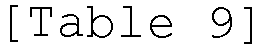

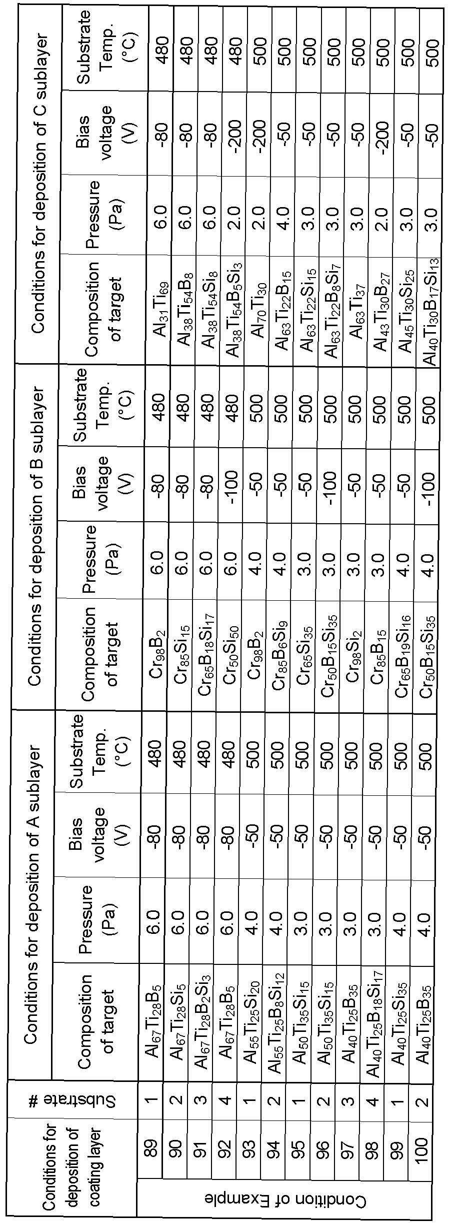

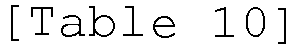

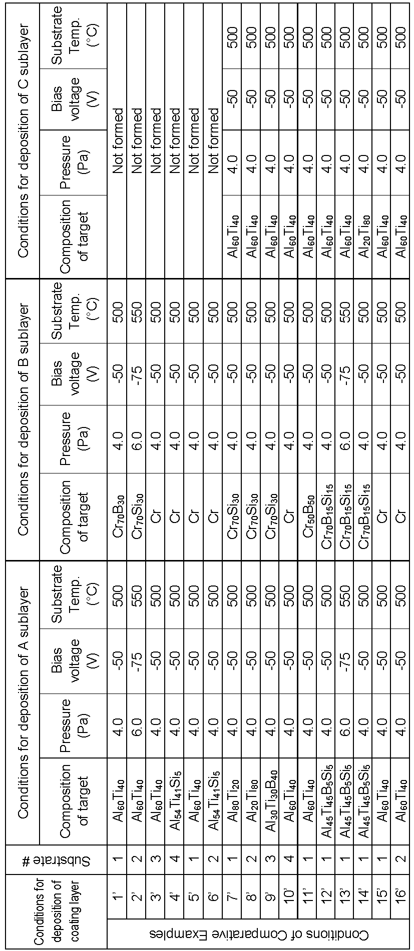

**[Table 11]**

| Layer | | Conditions of deposition | | | |
|---|---|---|---|---|---|
| | | Composition of target | Pressure (Pa) | Bias voltage (V) | Substrate Temp. (°C) |
| Base layer | AlCrN | Al₇₀Cr₃₀ | 3.5 | -45 | 480 |
| | AlTiN | Al₆₀Ti₄₀ | 3.5 | -45 | 480 |
| | AlTiSiN | Al₅₄Ti₄₁Si₅ | 3.5 | -45 | 480 |
| Top layer | TiN | Ti | 4.0 | -75 | 500 |

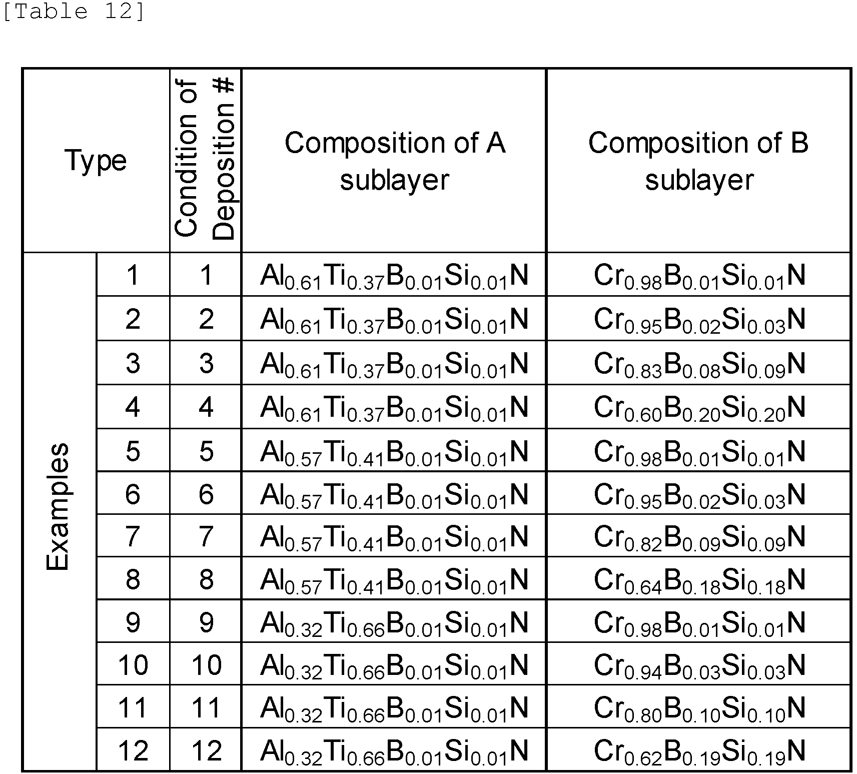

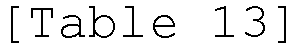

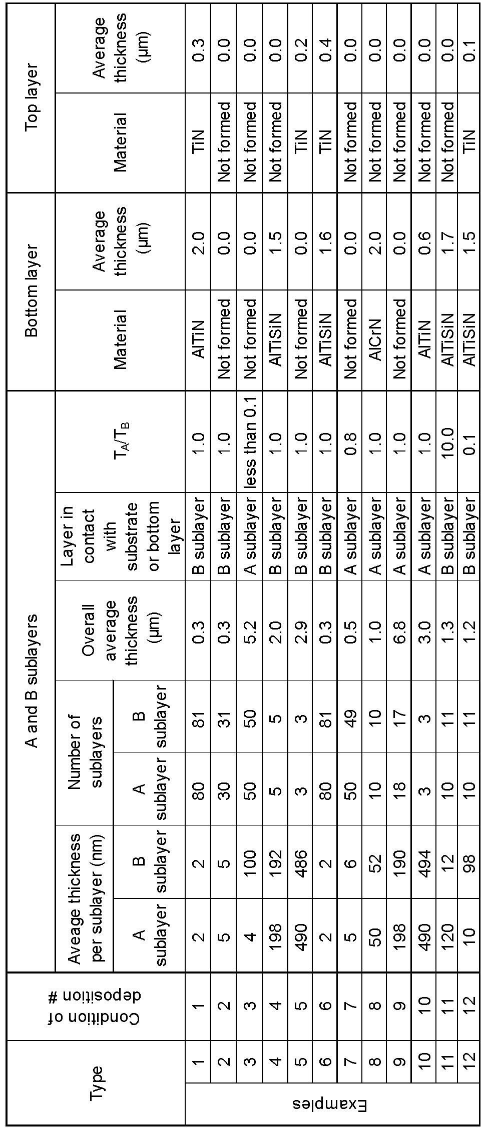

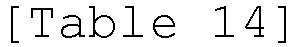

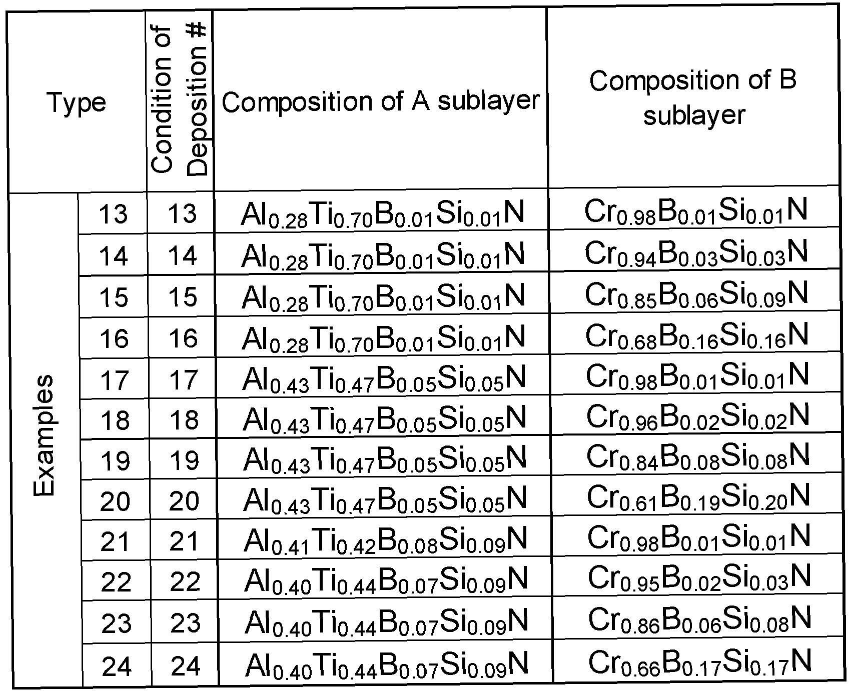

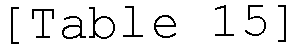

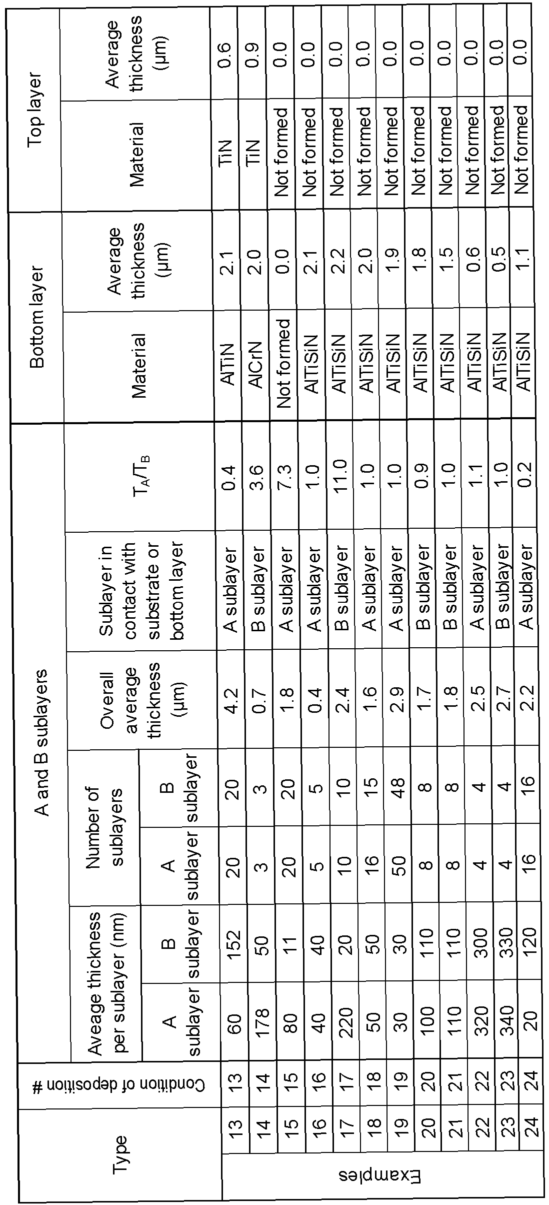

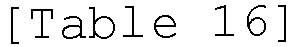

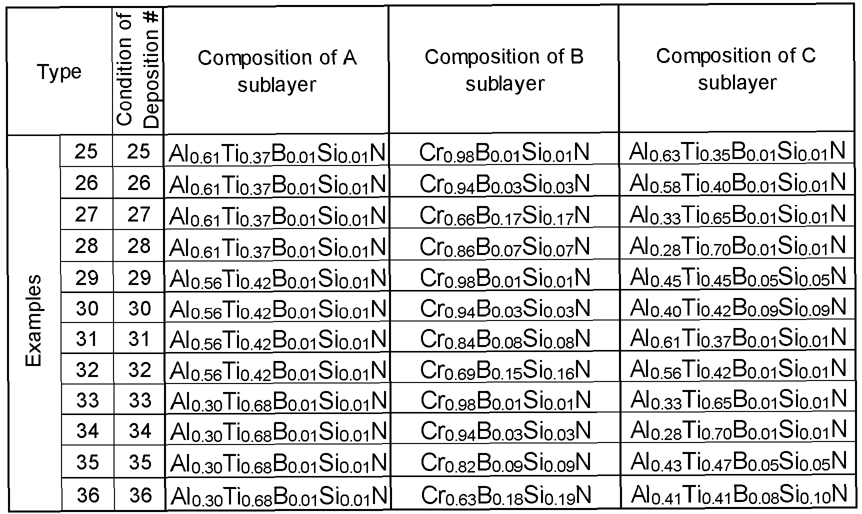

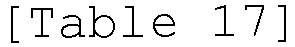

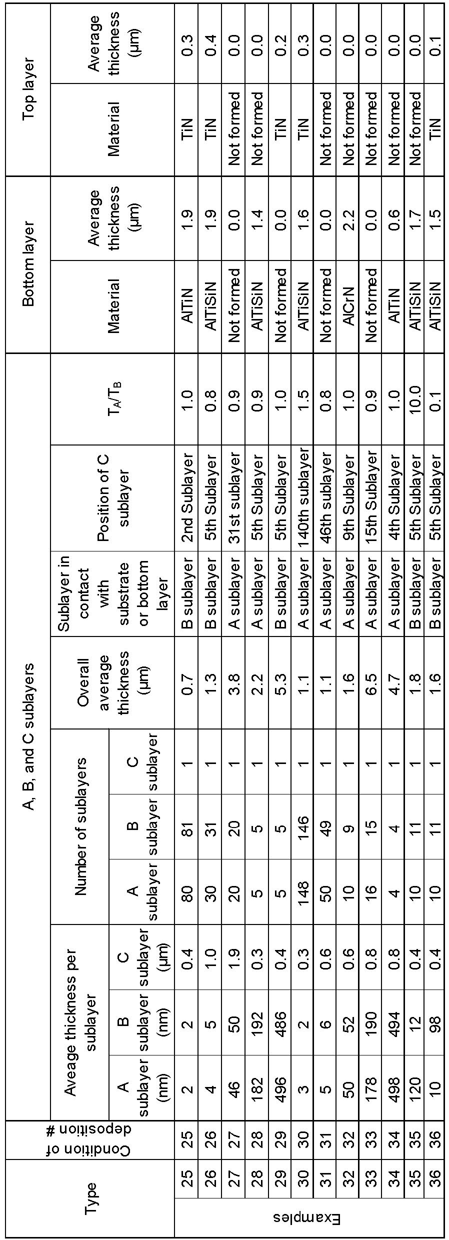

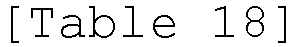

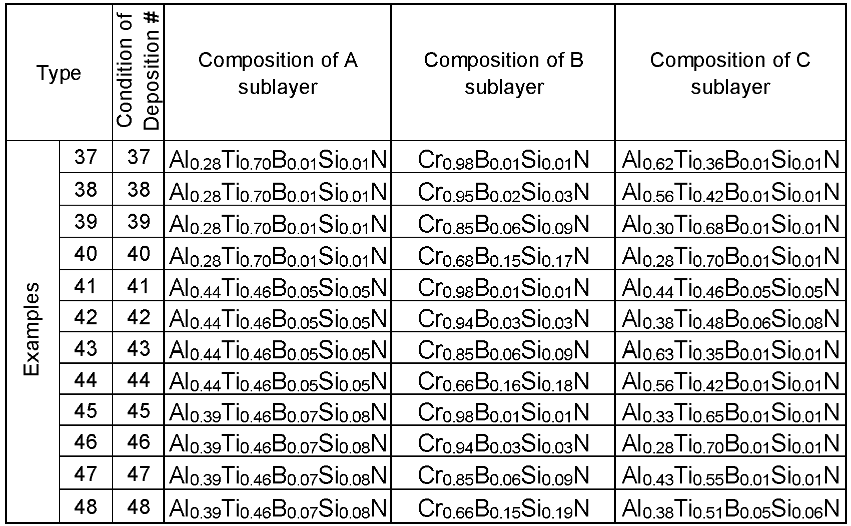

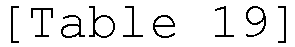

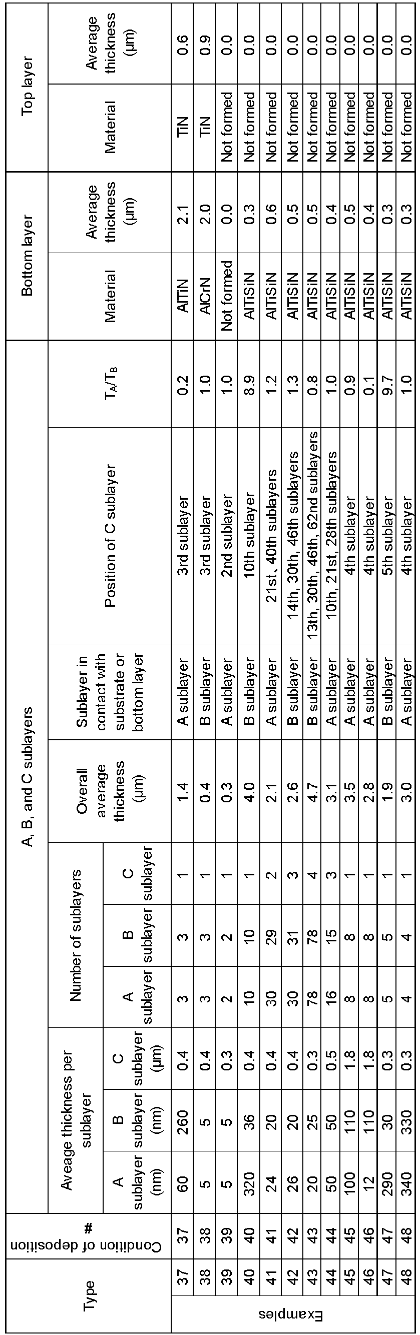

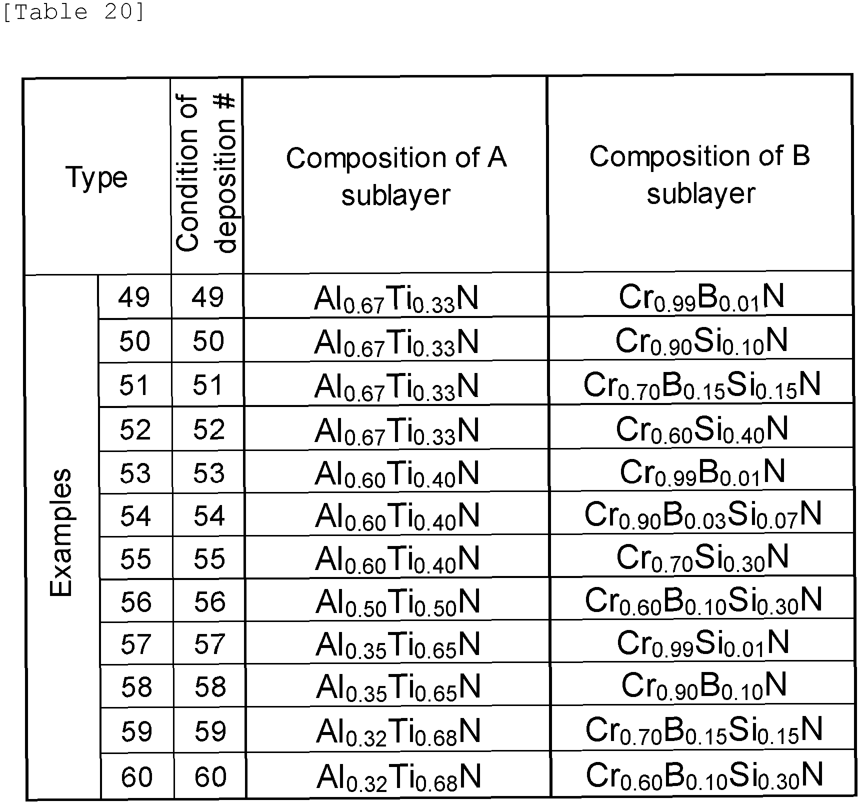

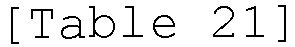

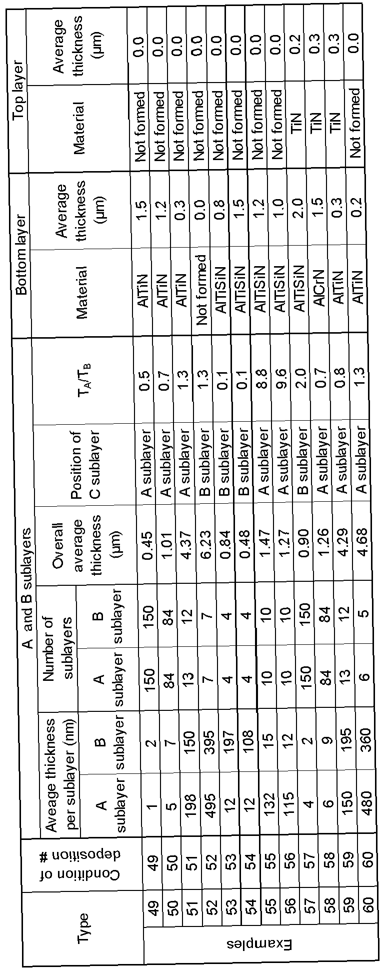

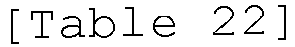

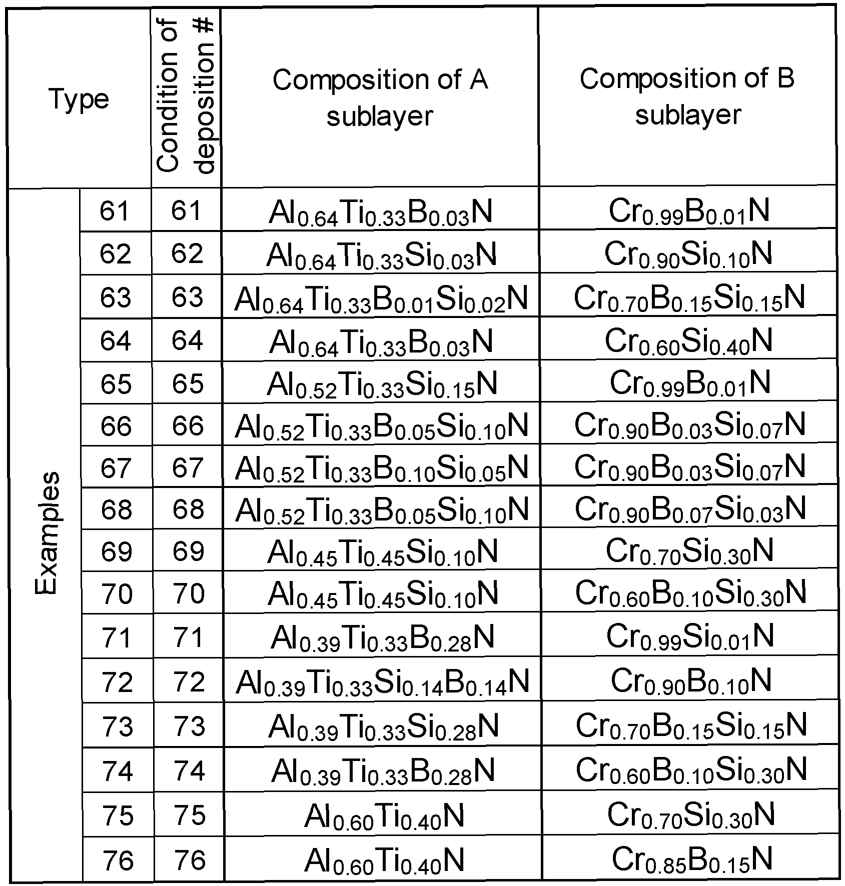

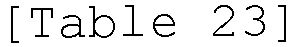

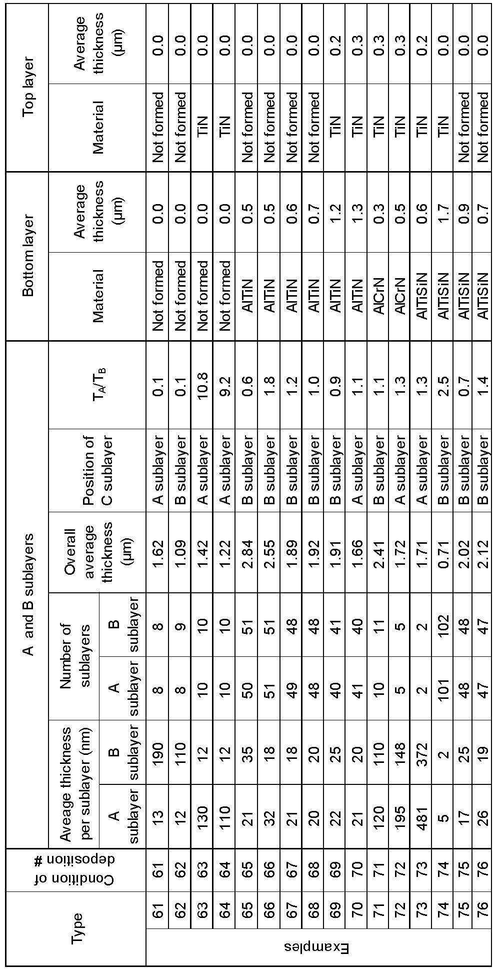

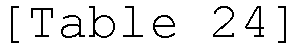

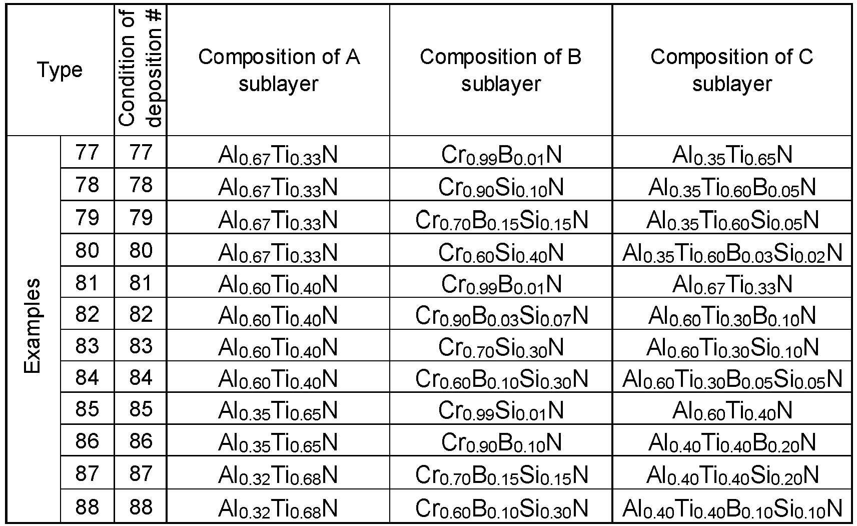

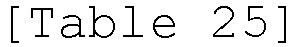

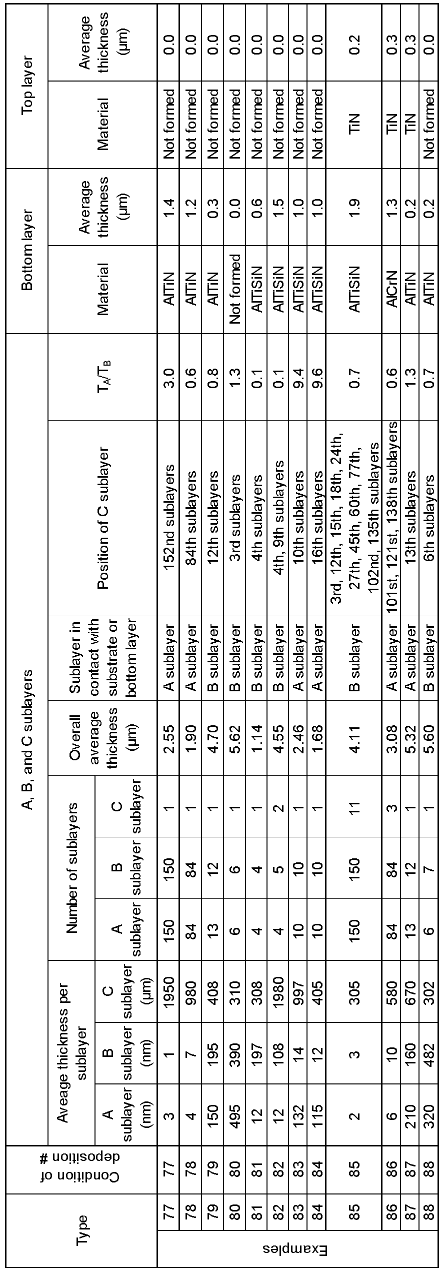

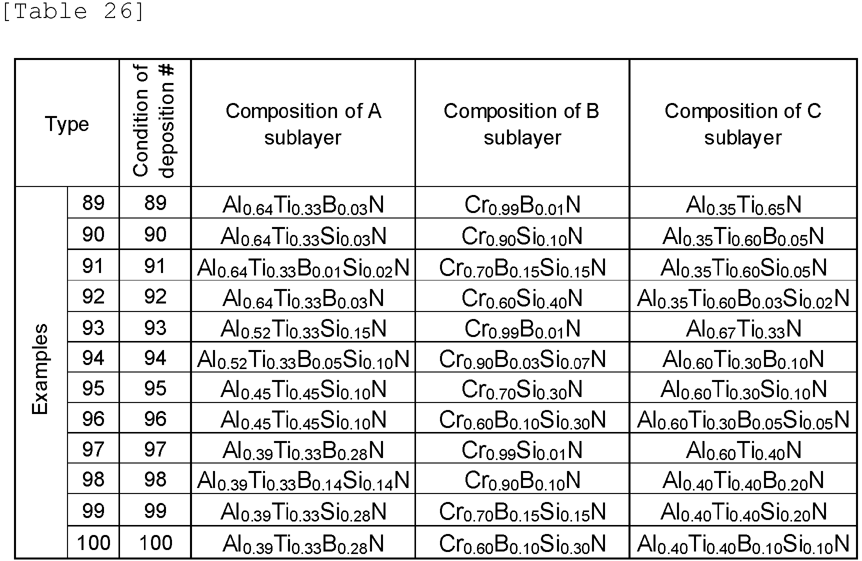

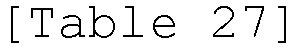

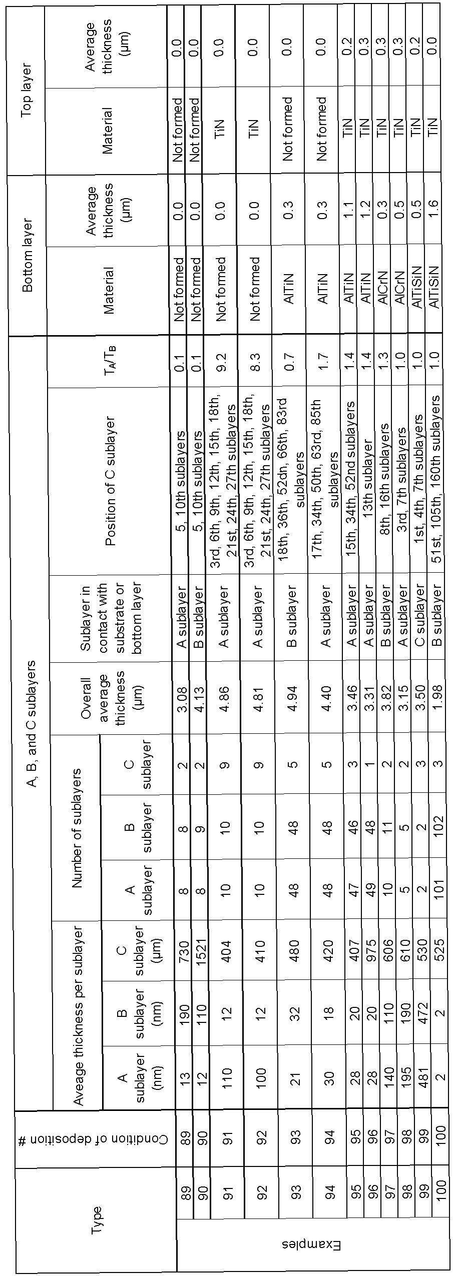

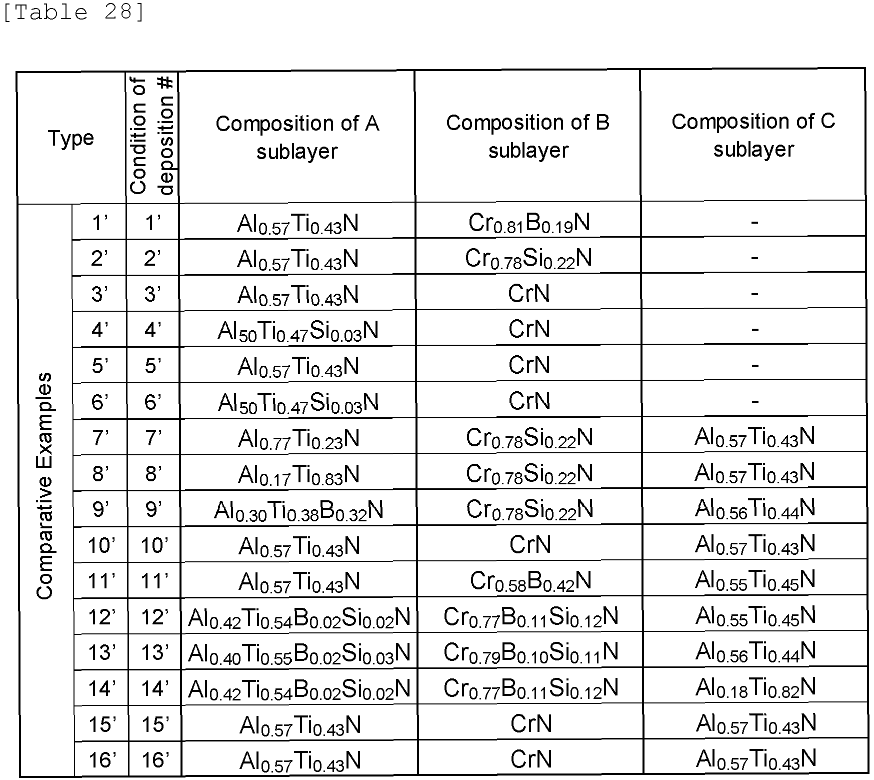

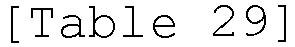

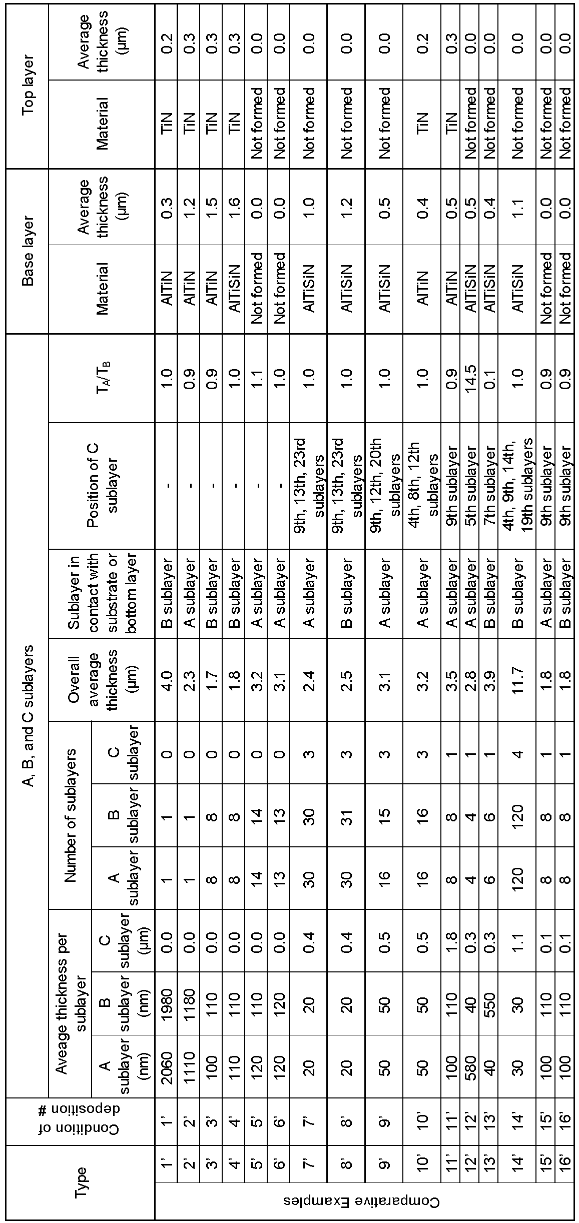

Each of the inserts of Examples 1 to 100 and Comparative Examples 1' to 16' was fixed to a milling chuck with a fixture, and subjected to a wet continuous cutting test against a Ti-based alloys under the following cutting conditions to measure the worn width of the flank face of the cutting edges in units of 10 µm.

### <Cutting conditions>

Workpiece: Ti-6Al-4V plate of 250 mm by 100 mm in flat dimen sion and 60 mm thick
Cutting speed: 100 m/min
Rotation speed: 5500 min⁻¹
Depth of cut: axial depth (ae) 0.3 mm, radial depth (ap) 6 m m
Feed rate (per tooth): 0.08 mm/tooth
Cutting length: 200 m
Cutting fluid: water-soluble coolant

Tables 21 to 28 show the results of cutting tests on Examples 1 to 100 and Comparative Examples 1' to 16'.

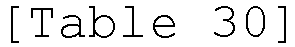

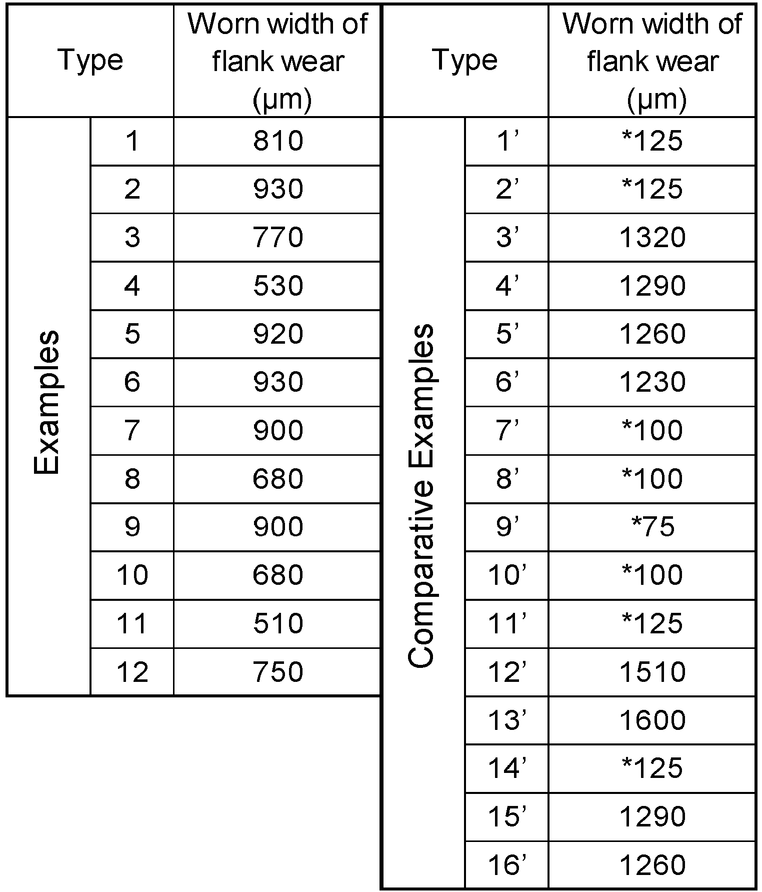

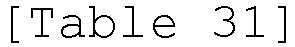

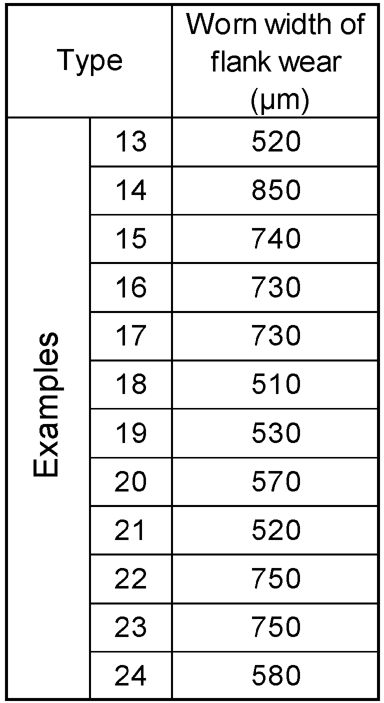

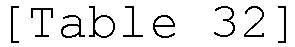

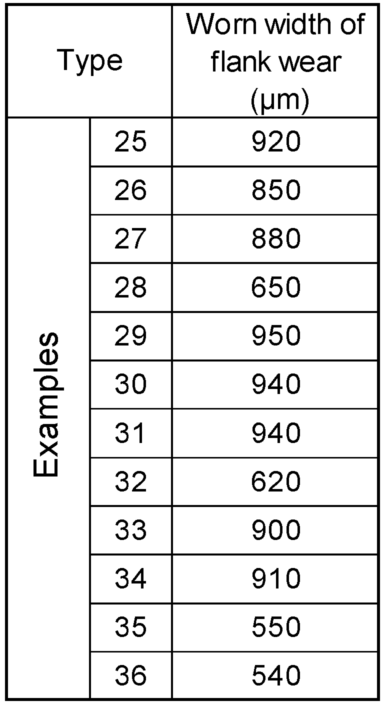

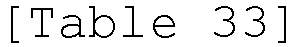

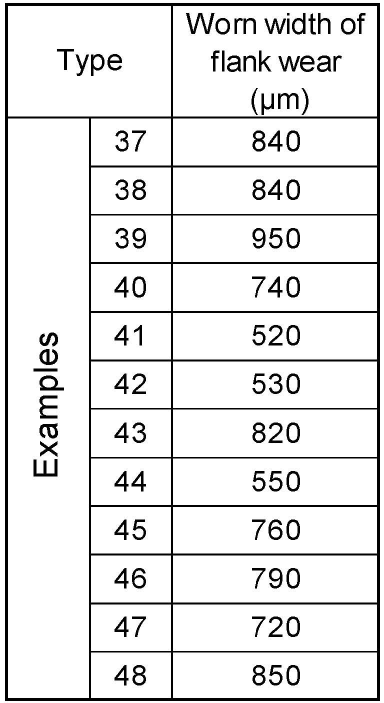

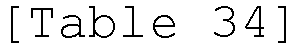

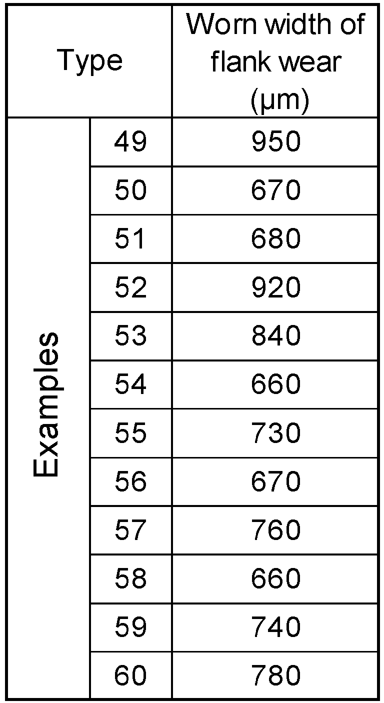

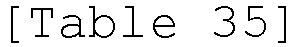

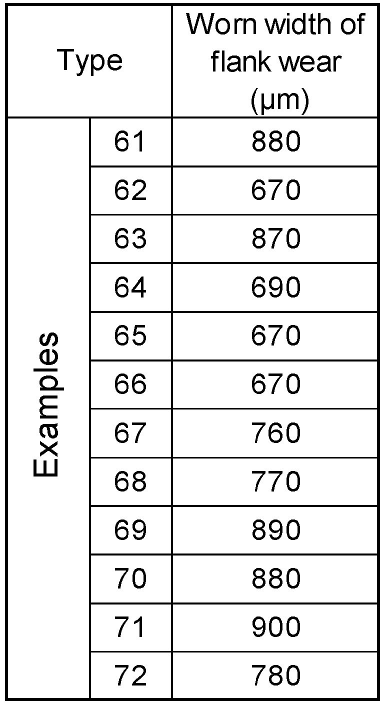

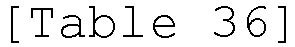

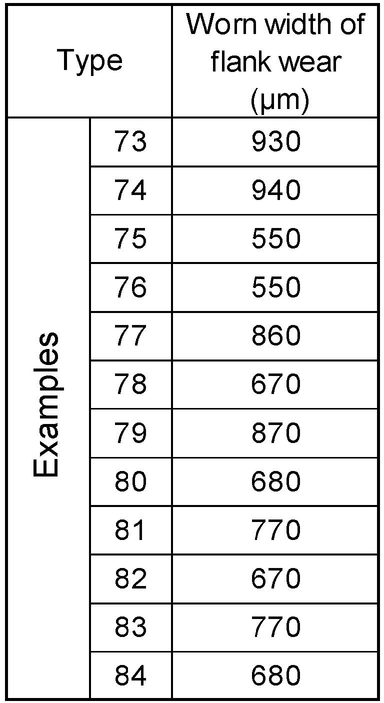

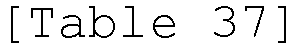

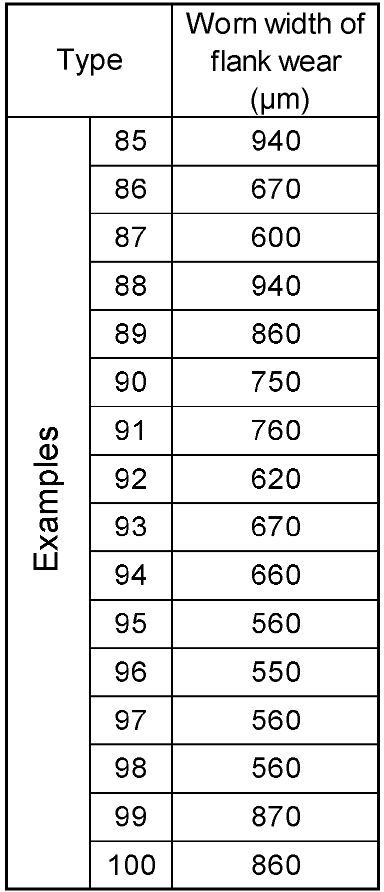

In Table 30, asterisk (*) in Comparative Examples indicates the cutting distance (m) until the end of service life due to delamination, welding, chipping, or wear.

The results shown in Tables 30 to 37 indicate that Examples 1 to 100 all have high durability, without delamination, welding, chipping or wear of the coating layer, even in high-speed cutting of Ti-based alloys.

In contrast, tools in Comparative Examples 1' to 16' all had short tool life due to delamination, welding, chipping or wear of the coating layer caused by thermal and mechanical loads during high-speed cutting of Ti-based alloys.

The coated tools of the present invention are expected to exhibit high durability even use in cutting materials, such as Ti-based alloys, Ni-based heat-resistant alloys, and stainless steels, which also have high weldability and are subject to large thermal and mechanical loads to the cutting edge.

The disclosed embodiments are in all respects illustrative only and are not restrictive. The scope of the invention is indicated by the claims, not the embodiments, and is intended to include all variations within the meaning and scope of the claims and equivalents.

### Reference Numerals

1 substrate
2 alternating layer of Ai and Bj sublayers
3 Ai sublayer
4 Bj sublayer
5 Ck sublayer
6 bottom layer
7 top layer
8 alternating layer of Ai and Bj sublayers with Ck sublayer disposed therebetween

## Claims

1. A surface-coated cutting tool comprising:
a substrate and a coating layer disposed on the substrate, wherein
1) the coating layer includes an alternating layer of A sublayers and B sublayers,
2) the A sublayers each have a composition represented by the formula: Al₁₋ₐTiₐN (where 0.30 ≤ a ≤ 0.70),
3) the B sublayers each have a composition represented by the formula: Cr_{1-c}M2_{c}N (where M2 is at least one selected from the group consisting of B and Si, where 0.01 ≤ c ≤ 0.40),
4) the A sublayers each have an average thickness of 1 nm or more and 500 nm or less and the B sublayers each have an average thickness of 1 nm or more and 500 nm or less,
5) the alternating layer of the A sublayers and the B sublayers has an average thickness of 0.3 um or more and 7.0 um or less, and
6) the adjoining A and B sublayers satisfy the relation: 0.1 ≤ T_{A}/T_{B} ≤ 0.8 or 1.2 ≤ T_{A}/T_{B} ≤ 10.0, where T_{A} represents the average thickness of the A sublayers and T_{B} represents the average thicknesses of the B sublayers.

2. The surface-coated cutting tool according to Claim 1, wherein
the alternating layer of the A sublayers and the B sublayers further includes one or more C sublayers with an average thickness of 0.3 um or more and 2.0 um or less at any position in the alternating layer, wherein the C sublayers each have a composition represented by the formula: Al_{1-d-e}Ti_{d}MSₑN (where M3 is at least one selected from the group consisting of B and Si, 0.30 ≤ d ≤ 0.70, 0.00 ≤ e ≤ 0.30, and d ≠ a).

3. A surface-coated cutting tool comprising:
a substrate and a coating layer disposed on the substrate, wherein
1) the coating layer includes an alternating layer of A sublayers and B sublayers,
2) the A sublayer each have a composition represented by the formula: Al_{1-a-b}TiₐM1_{b}N (where M1 is at least one selected from the group consisting of B and Si, 0.30 ≤ a ≤ 0.70, and 0.01 ≤ b ≤ 0.30).
3) the B sublayers each have a composition represented by the formula: Cr_{1-c}M2_{c}N (where M2 is at least one selected from the group consisting of B and Si, where 0.01 ≤ c ≤ 0.40),
4) the A sublayers each have an average thickness of 1 nm or more and 500 nm or less and the B sublayers each have an average thickness of 1 nm or more and 500 nm or less, and
5) the alternating layer of the A sublayers and the B sublayers has an average thickness of 0.3 um or more and 7.0 um or less.

4. The surface-coated cutting tool according to Claim 3, wherein
the adjoining A and B sublayers satisfy the relation: 0.1 ≤ T_{A}/T_{B} ≤ 10.0, where T_{A} represents the average thickness of the A sublayers and T_{B} represents the average thicknesses of the B sublayers.

5. The surface-coated cutting tool according to Claim 3 or 4, wherein
the alternating layer of the A sublayers and the B sublayers further includes one or more C sublayers with an average thickness of 0.3 um or more and 2.0 um or less at any position in the alternating layer, wherein the C sublayers each have a composition represented by the formula: Al_{1-d-e}TiₐM3ₑN (where M3 is at least one selected from the group consisting of B and Si, 0.30 ≤ d ≤ 0.70, 0.00 ≤ e ≤ 0.30, and d ≠ a and/or e ≠ b).
